# EUROPEAN PATENT APPLICATION

(11) **EP 4 682 856 A1**
(43) Date of publication of application: **21.01.2026**
(21) Application number: 23933828.8
(22) Date of filing: 20.11.2023
(51) Int. Cl.: G09F 9/00, H05K 5/00, H05K 5/02, H05K 5/06

(54) **ELECTRONIC DEVICE**

(30) Priority: 18.04.2023 CN 202320959015 U
(71) Applicant: Honor Device Co., Ltd., Shenzhen, Guangdong 518040 (CN)
(72) Inventor: ZHOU, Yongshan, Shenzhen, Guangdong 518040 (CN); XIAO, Guangnan, Shenzhen, Guangdong 518040 (CN); YUAN, Gao, Shenzhen, Guangdong 518040 (CN)
(74) Representative: Goddar, Heinz J.
(86) International application number: PCT/CN2023/132597
(87) International publication number: WO 2024/216962

(57) **Abstract**

Embodiments of this application provide an electronic device. The electronic device includes a middle frame, a display module, and a first sealing member. The middle frame includes a bottom wall and a side wall, and the bottom wall and the side wall jointly constitute an accommodating space. The display module is mounted in the accommodating space. The display module is parallel to the bottom wall of the middle frame. The display module includes a display panel. A bent portion is formed at one end of the display panel. There is a first gap between one side that is of the display module and that includes the bent portion and the bottom wall of the middle frame, and there is a second gap between the side that is of the display module and that includes the bent portion and a first side wall of the middle frame. The first side wall is a side wall opposite to the bent portion. The first sealing member is disposed at one end that is of the display module and that includes the bent portion, and is located in the first gap. An orthographic projection of the first sealing member on the bottom wall of the middle frame is located in a range of an orthographic projection of the display module on the bottom wall of the middle frame, and the first sealing member is not in contact with the first side wall of the middle frame. According to the electronic device of this application, contact areas between the first sealing member and both of the display module and the middle frame are reduced, thereby improving repairability of the electronic device.

## Description

This application claims priority to Chinese Patent Application No. 202320959015.5, filed with the China National Intellectual Property Administration on April 18, 2023 and entitled "ELECTRONIC DEVICE", which is incorporated herein by reference in its entirety.

### TECHNICAL FIELD

This application relates to the field of electronic product technologies, and in particular, to an electronic device.

### BACKGROUND

In recent years, with rapid development of electronic technologies, bezels of electronic devices such as a mobile phone and a pad gradually tend to be narrow. An electronic device in a related technology mainly includes a display module, a middle frame, a rear housing, and the like. Usually, the display module is fastened in the middle frame by using an adhesive, and the rear housing covers the middle frame. The display module includes a display panel, a bent portion is formed at an edge of the display panel, one end that is of the display module and that includes the bent portion is separately connected to a side wall of the middle frame and a bottom wall of the middle frame by using the adhesive, and the adhesive fully fills a space between the display module and the side wall of the middle frame, thereby implementing sealing of the bent portion while implementing a narrow bezel.

For such a fastening manner in which the adhesive fully fills the space between the end that is of the display module and that includes the bent portion and the side wall of the middle frame, a large amount of adhesive is required, and contact areas between the adhesive and both of the middle frame and the display module are also large. In this case, difficulty of disassembling the display module and the middle frame is increased, damages are easily caused to the display module and the middle frame during disassembly, and a residual adhesive amount after disassembly is also large and a residual adhesive is not easy to be cleaned. Consequently, the display module and the middle frame are difficult to be reused after disassembly, and repairability of the electronic device is poor.

### SUMMARY

An objective of embodiments of this application is to provide an electronic device, to reduce difficulty of disassembling the electronic device, and improve repairability of the electronic device. Specific technical solutions are as follows.

An embodiment of this application provides an electronic device. The electronic device includes a middle frame, a display module, and a first sealing member. The middle frame includes a bottom wall and a side wall, and the bottom wall and the side wall jointly constitute an accommodating space. The display module is mounted in the accommodating space. The display module is parallel to the bottom wall of the middle frame. The display module includes a display panel. A bent portion is formed at one end of the display panel. There is a first gap between one side that is of the display module and that includes the bent portion and the bottom wall of the middle frame, and there is a second gap between the side that is of the display module and that includes the bent portion and a first side wall of the middle frame. The first side wall is a side wall opposite to the bent portion. The first sealing member is disposed at one end that is of the display module and that includes the bent portion, and is located in the first gap. An orthographic projection of the first sealing member on the bottom wall of the middle frame is located in a range of an orthographic projection of the display module on the bottom wall of the middle frame, and the first sealing member is not in contact with the first side wall of the middle frame.

It can be learned from the foregoing that the electronic device in this embodiment of this application includes a middle frame, a display module, and a first sealing member. The bottom wall and the side wall of the middle frame jointly constitute the accommodating space. The display module is mounted in the accommodating space. The display module includes a display panel. The bent portion is formed at one end of the display panel. There is the first gap between the side that is of the display module and that includes the bent portion and the bottom wall of the middle frame, and there is the second gap between the side that is of the display module and that includes the bent portion and the first side wall of the middle frame. The first sealing member is disposed at the end that is of the display module and that includes the bent portion, and is located in the first gap. The orthographic projection of the first sealing member on the bottom wall of the middle frame is located in the range of the orthographic projection of the display module on the bottom wall of the middle frame, and the first sealing member is not in contact with the first side wall of the middle frame. Compared with a solution in a related technology in which an adhesive fully fills a space between the end that is of the display module and that includes the bent portion and the side wall of the middle frame, in this embodiment of this application, the display module is only fastened to the bottom wall of the middle frame by using the first sealing member, and is not fastened to the side wall of the middle frame by using the first sealing member, thereby reducing contact areas between the first sealing member and both of the display module and the middle frame, reducing difficulty of disassembling the electronic device, and reducing a probability of damaging the display module and the middle frame during disassembly. Correspondingly, an amount of residue of the first sealing member on the display module and the middle frame after disassembly is also reduced, and cleaning difficulty is reduced, so that reuse rates of the display module and the middle frame after disassembly are increased, thereby improving reparability of the electronic device.

In some embodiments of this application, the display panel further includes a display portion and a connection portion, the display portion is connected to the connection portion by using the bent portion, and the bent portion and the connection portion are formed by bending an extension region of the display portion toward a back side of the display portion, so that the connection portion is formed between the back side of the display portion and the bottom wall of the middle frame; and the electronic device further includes a first protective layer, and the first protective layer sheathes an outside of the bent portion, is located between the bent portion, the first side wall, and the bottom wall, and is not in contact with the first side wall and the bottom wall.

It can be learned from the foregoing that the bent portion of the display panel is relatively fragile, and the first protective layer sheathes the outside of the bent portion to protect the bent portion. When the electronic device is impacted, the middle frame deforms. The first protective layer is disposed to be not in contact with the first side wall and the bottom wall, so that the slightly deformed middle frame does not compress the first protective layer, and the bent portion is not damaged, thereby reducing failures of the display panel that are caused by impacting the electronic device.

In some embodiments of this application, one end that is of the first protective layer and that is close to the bottom wall extends from the bent portion to the first gap in a direction away from the first side wall, to form a first extension portion of the first protective layer; and the first sealing member is located between and is separately connected to the first extension portion and the bottom wall of the middle frame.

It can be learned from the foregoing that the first sealing member fastens the display module by using the first extension portion. Some residue of the first sealing member is left on the first protective layer during disassembly. Because the first protective layer is not an electrical connection structure in the display module, a probability of causing a display failure to the display panel during cleaning is low, thereby helping increase a reuse rate of the display module.

In some embodiments of this application, the display module further includes a circuit board, a chip, and a first sheathing member; the circuit board and the chip are disposed on one side that is of the connection portion and that faces the bottom wall of the middle frame; the first sheathing member sheathes an outside of the circuit board and an outside of the chip, and is located between both of the circuit board and the chip and the bottom wall of the middle frame, and the first gap is formed between the first sheathing member and the bottom wall; and the first extension portion of the first protective layer covers a portion of one end that is of the first sheathing member and that is close to the first side wall.

It can be learned from the foregoing that the first sheathing member sheathes the outside of the circuit board and the outside of the chip to protect the circuit board and the chip, thereby reducing cases of damaging the circuit board and the chip, and improving reliability of the display module.

In some embodiments of this application, the first sealing member is an adhesive and is prepared on the bottom wall of the middle frame through an adhesive dispensing process.

It can be learned from the foregoing that the adhesive dispensing process is easy to operate, thereby helping improve production efficiency.

In some embodiments of this application, one end that is of the first protective layer and that is close to the bottom wall extends, in a direction away from the first side wall, from the bent portion to one side that is of the connection portion and that faces the bottom wall, to form a second extension portion of the first protective layer; and the first sealing member is disposed between and separately connected to the connection portion of the display panel, the bottom wall of the middle frame, and the second extension portion.

It can be learned from the foregoing that the connection portion of the display panel, the bottom wall of the middle frame, and the second extension portion are all fastened to the first sealing member, to form an integrated structure, thereby helping improve structural stability of the display module.

In some embodiments of this application, the display module further includes a circuit board, a chip, and a second sheathing member; the circuit board and the chip are disposed on the side that is of the connection portion and that faces the bottom wall of the middle frame; the second sheathing member sheathes an outside of the circuit board and an outside of the chip, and is located between both of the circuit board and the chip and the bottom wall of the middle frame; and one end that is of the second sheathing member and that is close to the first side wall is spaced from the second extension portion of the first protective layer to form a third gap, and a portion of the first sealing member is disposed in the third gap, so that the first sealing member is separately connected to the second sheathing member, the connection portion of the display panel, the bottom wall of the middle frame, and the second extension portion.

It can be learned from the foregoing that the first sheathing member sheathes the outside of the circuit board and the outside of the chip to protect the circuit board and the chip, thereby reducing cases of damaging the circuit board and the chip, and improving reliability of the display module. The second sheathing member, the connection portion of the display panel, the bottom wall of the middle frame, and the second extension portion are all fastened to the first sealing member, to form an integrated structure, thereby helping improve structural stability of the display module.

In some embodiments of this application, the first sealing member includes a transition layer and a first adhesive layer; the transition layer of the first sealing member is disposed in the third gap; and the first adhesive layer is disposed between the transition layer and the bottom wall of the middle frame, and the transition layer is fastened to the bottom wall by using the first adhesive layer.

It can be learned from the foregoing that, during preparation, the transition layer may be first prepared in the third gap to ensure that the transition layer fully fills the third gap to ensure connection reliability, and then the first adhesive layer is prepared when the display module and the middle frame are assembled, to fasten the display module to the middle frame.

In some embodiments of this application, a material of the transition layer is PET, and the first adhesive layer is a back adhesive or an adhesive.

It can be learned from the foregoing that PET has excellent physical and mechanical performance in a wide temperature range, can be used at a temperature up to 120°C, has excellent electrical insulation performance, and has good size stability. Therefore, PET is applicable to the display module. The back adhesive is more favorable to disassembly than the adhesive.

In some embodiments of this application, the first sealing member is a foam adhesive, and the foam adhesive is disposed between and separately connected to the connection portion and the bottom wall of the middle frame; and one end that is of the foam adhesive and that is far away from the bottom wall of the middle frame is located in the third gap.

It can be learned from the foregoing that an operation of performing fastening by using the foam adhesive is simple, and costs are saved, thereby facilitating disassembly and reuse.

In some embodiments of this application, the display module further includes a heat dissipation layer; the heat dissipation layer is located on one side that is of the display portion of the display panel and that faces the bottom wall of the middle frame; the electronic device further includes a second sealing member, and the second sealing member is disposed between the heat dissipation layer and the bottom wall of the middle frame along an edge of the heat dissipation layer, and is separately fixedly connected to the heat dissipation layer and the bottom wall of the middle frame; the first sealing member extends in an extension direction of the first side wall, and two ends of the first sealing member are respectively connected to two ends of the second sealing member to form a ring-shaped structure; an orthographic projection of the heat dissipation layer on the display portion covers orthographic projections of the circuit board, the chip, the first sealing member, and the second sealing member on the display portion; and the heat dissipation layer, the bottom wall of the middle frame, the first protective layer, the first sealing member, and the second sealing member jointly constitute a sealing space, and the circuit board and the chip are located in the sealing space.

It can be learned from the foregoing that, in a process in which the electronic device works, the display panel generates heat, and a temperature gradually rises. A high temperature is adverse to working of the display panel, and the heat dissipation layer is configured to dissipate heat from the display module. The heat dissipation layer, the bottom wall of the middle frame, the first protective layer, the first sealing member, and the second sealing member jointly constitute the sealing space, and the circuit board and the chip are located in the sealing space, thereby implementing sealing of the circuit board and the chip, avoiding intrusion of external water and oxygen, and helping prolong a service life of the electronic device.

In some embodiments of this application, the display module further includes a first backplane, a second adhesive layer, and a second backplane; the first backplane is located between the display portion of the display panel and the heat dissipation layer; the second backplane is located on one side that is of the connection portion of the display panel and that is far away from the bottom wall of the middle frame; the second adhesive layer is located between the heat dissipation layer and the second backplane, and is configured to fasten the heat dissipation layer and the second backplane; the bent portion of the display panel is in an arc shape, and protrudes toward the first side wall of the middle frame to form an accommodating cavity; and a support member fully filling an entire space of the accommodating cavity is disposed in the accommodating cavity.

It can be learned from the foregoing that the first backplane plays a role of supporting the display portion of the display panel, and the second backplane plays a role of supporting the connection portion of the display panel. The bent portion of the display panel is relatively fragile. The support member is disposed in the accommodating cavity, and the support member fully fills the entire accommodating space of the accommodating cavity, to support the bent portion, thereby improving impact resistance of the bent portion.

In some embodiments of this application, the display module further includes a second protective layer; and the second protective layer is disposed between the first protective layer and the bent portion, the second protective layer sheathes the outside of the bent portion, and the first protective layer sheathes an outside of the second protective layer.

It can be learned from the foregoing that the second protective layer may protect the bent portion, and jointly protect the bent portion with the first protective layer, thereby further improving stability of the display panel.

In some embodiments of this application, the display module further includes a polarizer and an optically clear adhesive layer, the polarizer is disposed on one side that is of the display portion and that is far away from the bottom wall, and the optically clear adhesive layer is disposed on one side that is of the polarizer and that is far away from the display portion; the electronic device further includes a cover glass and an ink layer; a stepped structure is formed on the side wall of the middle frame, and the cover glass is fixedly connected to the side wall of the middle frame by using the stepped structure; the display module is disposed between the middle frame and the cover glass, and the cover glass is fastened to the display module by using the optically clear adhesive layer; and the ink layer is disposed between the cover glass and the side wall of the middle frame, is located between the optically clear adhesive layer and the cover glass, and covers the second gap.

It can be learned from the foregoing that the ink layer covers the second gap for shading.

### BRIEF DESCRIPTION OF DRAWINGS

To describe the technical solutions in the embodiments of this application or in the conventional technology more clearly, the following briefly describes the accompanying drawings required for describing the embodiments or the conventional technology. Clearly, the accompanying drawings in the following description show merely some embodiments of this application, and a person of ordinary skill in the art may still derive other embodiments from these accompanying drawings without creative efforts.
FIG. 1 is a schematic diagram of a structure of an electronic device according to an embodiment of this application;
FIG. 2 is a schematic diagram of an exploded structure of FIG. 1;
FIG. 3 is a first sectional view of FIG. 1 in a direction A-A;
FIG. 4 is a second sectional view of FIG. 1 in a direction A-A;
FIG. 5 is a third sectional view of FIG. 1 in a direction A-A;
FIG. 6 is a fourth sectional view of FIG. 1 in a direction A-A;
FIG. 7 is a diagram of a connection relationship of a heat dissipation layer, a connection portion, a circuit board, a chip, a first sealing member, and a second sealing member according to an embodiment of this application; and
FIG. 8 is a sectional view of FIG. 7 in a direction B-B.

Descriptions of reference numerals:
electronic device 10; display 11; housing 12; middle frame 100; bottom wall 110; side wall 120; first side wall 121; display module 200; display panel 210; bent portion 211; display portion 212; connection portion 213; circuit board 220; chip 230; first sheathing member 241; second sheathing member 242; heat dissipation layer 251; first backplane 252; second adhesive layer 253; second backplane 254; support member 260; second protective layer 270; polarizer 280; optically clear adhesive layer 290; first sealing member 300; foam adhesive 301; transition layer 310; first adhesive layer 320; back adhesive 321; first protective layer 400; first extension portion 410; second extension portion 420; second sealing member 500; cover glass 600; ink layer 700; rear housing 800; battery 900; first gap a; second gap b; and third gap c.

### DESCRIPTION OF EMBODIMENTS

To make the objectives, technical solutions, and advantages of the present invention clearer and more comprehensible, the following further describes the present invention with reference to the accompanying drawings and embodiments. It is clear that the described embodiments are merely some rather than all of embodiments of the present invention. All other embodiments obtained by a person of ordinary skill in the art based on embodiments of the present invention shall fall within the protection scope of the present invention.

To better understand the technical solutions of this application, the following describes embodiments of this application in detail with reference to the accompanying drawings.

To clearly describe the technical solutions in the embodiments of this application, in the embodiments of this application, words such as "first" and "second" are used to distinguish between same items or similar items with basically the same functions and effects. For example, a first extension portion and a second extension portion are merely intended to distinguish between different extension portions, but not to limit a sequence of the extension portions. A person skilled in the art may understand that the words such as "first" and "second" do not limit a quantity and a position, and the words such as "first" and "second" do not indicate a definite difference.

It should be noted that in this application, words such as "example" or "for example" are used to indicate an example, an illustration, or a description. Any embodiment or design solution described as "example" or "for example" in this application should not be construed as being preferred or advantageous over other embodiments or design solutions. Exactly, use of the words such as "example" or "for example" is intended to present a related concept in a specific manner.

An electronic device in the embodiments of this application may be referred to as user equipment (user equipment, UE), a terminal (terminal), or the like. For example, the electronic device may be a mobile terminal or a fixed terminal with a display, for example, a mobile phone, a portable android device (portable android device, PAD), a notebook computer, an ultra-mobile personal computer (ultra-mobile personal computer, UMPC), a handheld computer, a walkie-talkie, a netbook, a POS terminal, a personal digital assistant (personal digital assistant, PDA), a wearable device, a vehicle-mounted device, a computing device, a watch, a virtual reality (virtual reality, VR) device, a wireless terminal in remote medical (remote medical), a wireless terminal in smart city (smart city), or a wireless terminal in smart home (smart home). A form of a terminal device is not specifically limited in the embodiments of this application.

For example, the electronic device is a mobile phone. The electronic device may be a foldable mobile phone or a bar-type mobile phone. In the embodiments of this application, description is provided with an example in which the mobile phone is a bar-type mobile phone.

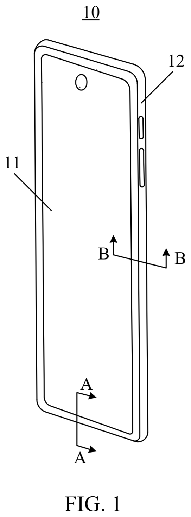

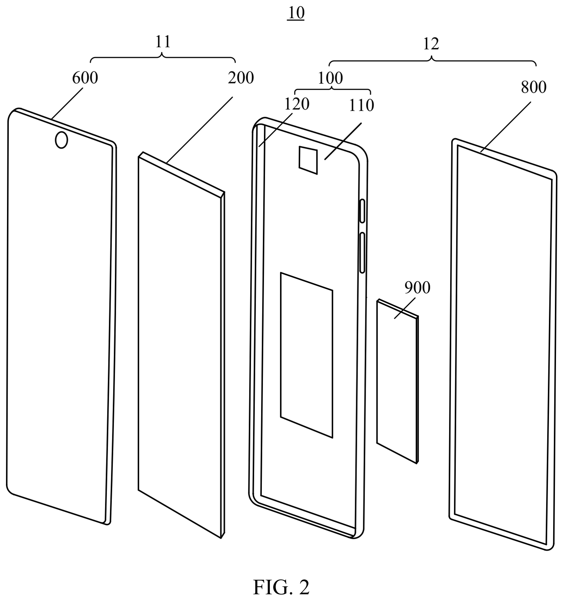

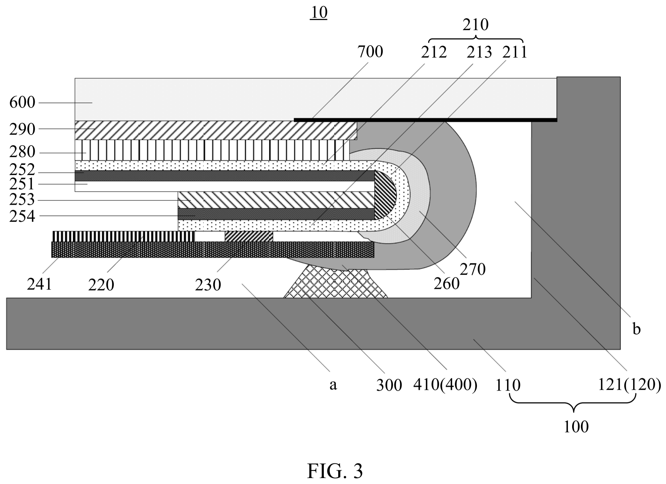

FIG. 1 is a schematic diagram of a structure of an electronic device 10 according to an embodiment of this application. FIG. 2 is a schematic exploded view of an electronic device 10 according to an embodiment of this application. FIG. 3 is a sectional view of an electronic device 10 according to an embodiment of this application in a direction A-A.

Refer to FIG. 1. The electronic device 10 may include a display 11 and a housing 12. The housing 12 may provide structural support for the electronic device 10, and a structural member that forms the electronic device 10 may be disposed on the housing 12. Refer to FIG. 2. For example, the electronic device 10 may further include a display 11 and a battery 900. The foregoing structural members may be disposed on the housing 12. The housing 12 may include a middle frame 100 and a rear housing 800 that are connected to each other, and the display 11 may be disposed on the middle frame 100. For example, the display 11 may be disposed on one side that is of the middle frame 100 and that faces away from the rear housing 800. The battery 900 may be disposed on one side that is of the middle frame 100 and that faces the rear housing 800.

The middle frame 100 and the rear housing 800 may be of an integrated structure. For example, the housing 12 may be formed integrally. In this way, fastness and reliability of connection between the middle frame 100 and the rear housing 800 can be improved, thereby helping improve integrity of the housing 12. Alternatively, the middle frame 100 and the rear housing 800 may alternatively be of a split structure. For example, the middle frame 100 and the rear housing 800 may be separately formed first, and then the middle frame 100 and the rear housing 800 are assembled to form a complete housing 12, thereby facilitating mounting of other structural members (for example, the display 11 and the battery 900) on the middle frame 100, and helping improve assembly efficiency of the electronic device 10. For example, the middle frame 100 is connected to the rear housing 800 through welding, clamping, buckling, adhering, or the like.

The display 11 may be configured to display an image, for example, display status information, power information, a time, a video, a photo, and the like of the electronic device 10. Refer to FIG. 2. The display 11 may include a display module 200 and a cover glass 600 that covers the display module 200. An edge of the cover glass 600 may cover the middle frame 100 and be hermetically connected to the middle frame 100, so that the display module 200 can be sealed in the housing 12. Refer to FIG. 3. FIG. 3 is a sectional view of FIG. 1 in a direction A-A. The display module 200 may include a display panel 210 and a circuit board 220 stacked with the display panel 210. A touch line (not shown in the figure) is disposed on the display panel 210, and the display panel 210 may be electrically connected to the circuit board 220, so that the touch line on the display panel 210 can be electrically connected to the circuit board 220. When a user touches the display 11 by using the cover glass 600, the touch line on the display panel 210 may sense a touch of the user, and make a response according to a position or an action of the touch. One end of the display panel 210 may be bent toward the circuit board 220 to be electrically connected to the circuit board 220. A bent portion of the display panel 210 may form a bent portion 211, so that the display panel 210 can be electrically connected to the circuit board 220 by using the bent portion 211. For example, the bent portion 211 may be located at a bottom of the electronic device 10, and the bent portion 211 may protrude toward a side wall of the housing 12, and the side wall of the housing 12 may be specifically a side wall 120 of the middle frame 100.

In recent years, with rapid development of electronic technologies, bezels of electronic devices such as a mobile phone and a pad gradually tend to be narrow. In a related technology, a display module is usually fastened in a middle frame by using an adhesive, and a rear housing covers the middle frame. One end that is of the display module and that includes a bent portion is separately connected to a side wall of the middle frame and a bottom wall of the middle frame by using the adhesive, and the adhesive fully fills a space between the display module and the side wall of the middle frame, thereby implementing sealing of the bent portion while implementing a narrow bezel.

For such a fastening manner in which the adhesive fully fills the space between the end that is of the display module and that includes the bent portion and the side wall of the middle frame, a large amount of adhesive is required, and contact areas between the adhesive and both of the middle frame and the display module are also large. In this case, difficulty of disassembling the display module and the middle frame is increased, damages are easily caused to the display module and the middle frame during disassembly, and a residual adhesive amount after disassembly is also large and a residual adhesive is not easy to be cleaned. Consequently, the display module and the middle frame are difficult to be reused after disassembly, and repairability of the electronic device is poor.

Based on the foregoing problems, embodiments of this application provide an electronic device, to reduce, through fitting between a first sealing member disposed to be not in contact with a side wall and another component, difficulty of disassembling the electronic device, thereby improving repairability of the electronic device.

As shown in FIG. 3, in a first embodiment of this application, an electronic device 10 includes a middle frame 100, a display module 200, and a first sealing member 300. Specifically, the middle frame 100 includes a bottom wall 110 and a side wall 120, and the bottom wall 110 and the side wall 120 jointly constitute an accommodating space. The display module 200 is mounted in the accommodating space, and the display module 200 is parallel to the bottom wall 110 of the middle frame 100. The display module 200 includes a display panel (panel) 210, and a bent portion 211 is formed at one end of the display panel 210. There is a first gap a between one side that is of the display module 200 and that includes the bent portion 211 and the bottom wall 110 of the middle frame 100, and there is a second gap b between the side that is of the display module 200 and that includes the bent portion 211 and a first side wall 121 of the middle frame 100. The first side wall 121 is a side wall 120 opposite to the bent portion 211. The first sealing member 300 is disposed at one end that is of the display module 200 and that includes the bent portion 211, and is located in the first gap a. An orthographic projection of the first sealing member 300 on the bottom wall 110 of the middle frame 100 is located in a range of an orthographic projection of the display module 200 on the bottom wall 110 of the middle frame 100, and the first sealing member 300 is not in contact with the first side wall 121 of the middle frame 100.

The electronic device 10 in this embodiment of this application includes a middle frame 100, a display module 200, and a first sealing member 300. The bottom wall 110 and the side wall 120 of the middle frame 100 jointly constitute the accommodating space. The display module 200 is mounted in the accommodating space. The display module 200 includes a display panel 210, and the bent portion 211 is formed at one end of the display panel 210. There is the first gap a between the side that is of the display module 200 and that includes the bent portion 211 and the bottom wall 110 of the middle frame 100, and there is the second gap b between the side that is of the display module 200 and that includes the bent portion 211 and the first side wall 121 of the middle frame 100. The first sealing member 300 is disposed at the end that is of the display module 200 and that includes the bent portion 211, and is located in the first gap a. The orthographic projection of the first sealing member 300 on the bottom wall 110 of the middle frame 100 is located in the range of the orthographic projection of the display module 200 on the bottom wall 110 of the middle frame 100, and the first sealing member 300 is not in contact with the first side wall 121 of the middle frame 100.

As shown in FIG. 3, the first gap a and the second gap b are communicated before the first sealing member 300 is mounted, and the first gap a and the second gap b constitute a space between the end that is of the display module 200 and that includes the bent portion 211 and the side wall 120 of the middle frame 100.

Compared with a solution in a related technology in which an adhesive fully fills the space between the end that is of the display module 200 and that includes the bent portion 211 and the side wall 120 of the middle frame 100, in this embodiment of this application, the display module 200 is only fastened to the bottom wall 110 of the middle frame 100 by using the first sealing member 300, and is not fastened to the side wall 120 of the middle frame 100 by using the first sealing member 300, thereby reducing contact areas between the first sealing member 300 and both of the display module 200 and the middle frame 100, reducing difficulty of disassembling the electronic device 10, and reducing a probability of damaging the display module 200 and the middle frame 100 during disassembly. Correspondingly, an amount of residue of the first sealing member 300 on the display module 200 and the middle frame 100 after disassembly is also reduced, and cleaning difficulty is reduced, so that reuse rates of the display module 200 and the middle frame 100 after disassembly are increased, thereby improving reparability of the electronic device 10.

It can be understood that the display panel 210 has a display side and a non-display side. The bottom wall 110 of the middle frame 100 is located on the non-display side of the display panel 210. There may be two bent portions 211, for example, the two bent portions 211 may be formed by bending two opposite ends of the display panel 210 separately toward the non-display side of the display panel 210. In this case, two sides of the display module 200 may be connected to the bottom wall 110 of the middle frame 100 by using the first sealing member 300, and not in contact with the corresponding side wall 120.

In the embodiment shown in FIG. 3, the display panel 210 further includes a display portion 212 and a connection portion 213. The display portion 212 is connected to the connection portion 213 by using the bent portion 211. The bent portion 211 and the connection portion 213 are formed by bending an extension region of the display portion 212 toward a back side of the display portion 212, so that the connection portion 213 is formed between the back side of the display portion 212 and the bottom wall 110 of the middle frame 100. The electronic device 10 further includes a first protective layer 400, and the first protective layer 400 sheathes an outside of the bent portion 211, is located between the bent portion 211, the first side wall 121, and the bottom wall 110, and is not in contact with the first side wall 121 and the bottom wall 110.

Because the bent portion 211 of the display panel 210 is relatively fragile, the first protective layer 400 sheathes the outside of the bent portion 211 to protect the bent portion 211. When the electronic device 10 is impacted, the middle frame 100 deforms. The first protective layer 400 is disposed to be not in contact with the first side wall 121 and the bottom wall 110, so that the slightly deformed middle frame 100 does not compress the first protective layer 400, and the bent portion 211 is not damaged, thereby reducing failures of the display panel 210 that are caused by impacting the electronic device 10.

In the embodiment shown in FIG. 3, one end that is of the first protective layer 400 and that is close to the bottom wall 110 extends from the bent portion 211 to the first gap a in a direction away from the first side wall 121, to form a first extension portion 410 of the first protective layer 400. The first sealing member 300 is located between and is separately connected to the first extension portion 410 and the bottom wall 110 of the middle frame 100.

In this way, the first sealing member 300 fastens the display module 200 by using the first extension portion 410. Some residue of the first sealing member 300 is left on the first protective layer 400 during disassembly. Because the first protective layer 400 is not an electrical connection structure in the display module 200, a probability of causing a display failure to the display panel 210 during cleaning is low, thereby helping increase a reuse rate of the display module 200.

Specifically, the first protective layer 400 may be an adhesive layer, and may be prepared through an adhesive dispensing process, which may be referred to as outer adhesive dispensing. Adhesive dispensing, also referred to as adhesive applying, adhesive coating, adhesive potting, and adhesive dropping, is a process of coating, potting, or dropping an electronic adhesive, oil, or other liquid onto a product, to play roles such as adhering, potting, insulation, fastening, surface smoothening for the product.

In the embodiment shown in FIG. 3, the display module 200 further includes a circuit board 220, a chip (IC) 230, and a first sheathing member 241. The circuit board 220 and the chip 230 are disposed on one side that is of the connection portion 213 and that faces the bottom wall 110 of the middle frame 100. The first sheathing member 241 sheathes an outside of the circuit board 220 and an outside of the chip 230, and is located between both of the circuit board 220 and the chip 230 and the bottom wall 110 of the middle frame 100. The first gap a is formed between the first sheathing member 241 and the bottom wall 110. The first extension portion 410 of the first protective layer 400 covers a portion of one end that is of the first sheathing member 241 and that is close to the first side wall 121.

The circuit board 220 and the chip 230 are electrically connected to the connection portion 213 of the display panel 210. The first sheathing member 241 sheathes the outside of the circuit board 220 and the outside of the chip 230 to protect the circuit board 220 and the chip 230, thereby reducing cases of damaging the circuit board 220 and the chip 230, and helping improve reliability of the display module 200.

Specifically, the circuit board 220 may be an FPC (Flexible Printed Circuit, flexible printed circuit), and the first sheathing member 241 may be a TAPE (tape).

The connection portion 213 of the display panel 210 is a COP (Chip On Panel) region of the display panel 210. As shown in FIG. 3, the first extension portion 410 of the first protective layer 400 covers the portion of the end that is of the first sheathing member 241 and that is close to the first side wall 121, that is, the first extension portion 410 overlaps with the end that is of the first sheathing member 241 and that is close to the first side wall 121. The circuit board 220 and the chip 230 are located on one side that is of an overlapping position and that is far away from the first side wall 121. In this case, the overlapping position is a non-COP-sensitive region, and disposing the first sealing member 300 in this region is conducive to reducing the failures of the display module 200 that are caused by disassembly.

Specifically, the first sealing member 300 may be formed through low-volume silicone dispensing in a single line, which may be referred to as middle frame adhesive dispensing. In this case, a disassembly effect is more ideal, and dispensed silicone mainly remains on the middle frame 100, so that the middle frame 100 can be reused after the silicone is wiped off by using alcohol or isopropyl alcohol. In addition, when the first sealing member 300 is an epoxy adhesive with a high modulus, strength of the display module 200 is better improved. Performing silicone dispensing between the epoxy adhesive and the bottom wall 110 of the middle frame 100 is more conducive to disassembly and reuse.

In the embodiment shown in FIG. 3, the first sealing member 300 may be an adhesive, and is prepared on the bottom wall 110 of the middle frame 100 through an adhesive dispensing process. Because the adhesive dispensing process is easy to operate, the adhesive dispensing process helps improve production efficiency.

In the embodiment shown in FIG. 3, in addition to the display panel 210, the display module 200 further includes a heat dissipation layer 251, a first backplane 252, a second adhesive layer 253, a second backplane 254, a support member 260, a second protective layer 270, a polarizer (Polarizer, POL) 280, and an optically clear adhesive (Optically Clear Adhesive, OCA) layer 290.

The heat dissipation layer 251 is located on one side that is of the display portion 212 of the display panel 210 and that faces the bottom wall 110 of the middle frame 100.

In a process in which the electronic device 10 works, the display panel 210 generates heat, and a temperature gradually rises. A high temperature is adverse to working of the display panel 210, and the heat dissipation layer 251 is configured to dissipate heat from the display module 200. Specifically, the heat dissipation layer 251 may be an SCF (Super Composite Film, copper foil tape). Heat conductivity of copper is good, and heat dissipation can be effectively implemented.

The first backplane 252 is located between the display portion 212 of the display panel 210 and the heat dissipation layer 251. The second backplane 254 is located on one side that is of the connection portion 213 of the display panel 210 and that is far away from the bottom wall 110 of the middle frame 100. The second adhesive layer 253 is located between the heat dissipation layer 251 and the second backplane 254, and is configured to fasten the heat dissipation layer 251 and the second backplane 254.

The first backplane 252 may be disposed to be in contact with and support the display portion 212 of the display panel 210. The second backplane 254 may be disposed to be in contact with and support the connection portion 213 of the display panel 210. Specifically, a material of the second adhesive layer 253 may be a foam (foamed rubber) adhesive. The heat dissipation layer 251 may be disposed to be in direct contact with the first backplane 252, to perform heat dissipation on the display panel 210.

The bent portion 211 of the display panel 210 is in an arc shape, and protrudes toward the first side wall 121 of the middle frame 100 to form an accommodating cavity. The support member 260 fully filling an entire space of the accommodating cavity is disposed in the accommodating cavity.

The bent portion 211 of the display panel 210 is relatively fragile. The support member 260 is disposed in the accommodating cavity, and the support member 260 fully fills the entire accommodating space of the accommodating cavity, to support the bent portion 211, thereby improving impact resistance of the bent portion 211. Specifically, the support member 260 may be an adhesive, and is prepared through an adhesive dispensing process.

The second protective layer 270 is disposed between the first protective layer 400 and the bent portion 211, the second protective layer 270 sheathes the outside of the bent portion 211, and the first protective layer 400 sheathes an outside of the second protective layer 270. The second protective layer 270 protects the bent portion 211, and jointly protects the bent portion 211 with the first protective layer 400, thereby further improving stability of the display panel 210. Specifically, the second protective layer 270 may be prepared by using an MCL adhesive.

The polarizer 280 is disposed on one side that is of the display portion 212 and that is far away from the bottom wall 110, and the optically clear adhesive layer 290 is disposed on one side that is of the polarizer 280 and that is far away from the display portion 212.

In the embodiment shown in FIG. 3, the electronic device 10 further includes an ink layer 700. A stepped structure is formed on the side wall 120 of the middle frame 100, and a cover glass (CG) 600 is fixedly connected to the side wall 120 of the middle frame 100 by using the stepped structure. The display module 200 is disposed between the middle frame 100 and the cover glass 600, and the cover glass 600 is fastened to the display module 200 by using the optically clear adhesive layer 290. The ink layer 700 is disposed between the cover glass 600 and the side wall 120 of the middle frame 100, is located between the optically clear adhesive layer 290 and the cover glass 600, and covers the second gap b. The ink layer 700 plays a role of shading. Specifically, the ink layer 700 may be disposed at an edge of the display panel 210, and forms a ring, to implement a good shading effect.

In the embodiment shown in FIG. 3, the first sealing member 300 may be a dispensed adhesive. In another embodiment, the first sealing member 300 may include a transition layer 310 and an adhesive layer made of a different material.

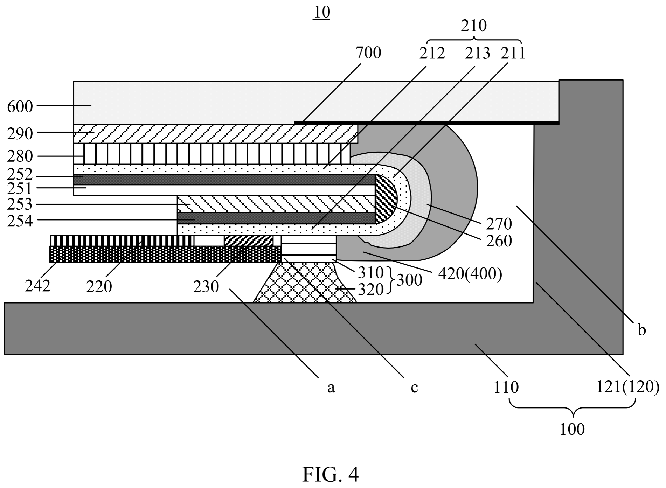

In an embodiment shown in FIG. 4, the electronic device 10 in this embodiment also includes a display module 200, a middle frame 100, and a first sealing member 300. A structure of the display module 200 may be similar to a structure of the display module 200 in the embodiment shown in FIG. 3. A difference lies in that a structure of the second sheathing member 242 is not disposed in a manner completely the same as that of the first sheathing member 241 in the embodiment shown in FIG. 3, and the first protective layer 400 is disposed in a manner different from that of the first protective layer 400 in the embodiment shown in FIG. 3. In addition, the first sealing member 300 in this embodiment is different from the first sealing member 300 in the embodiment shown in FIG. 3.

Specifically, as shown in FIG. 4, one end that is of the first protective layer 400 and that is close to the bottom wall 110 extends, in a direction away from the first side wall 121, from the bent portion 211 to one side that is of the connection portion 213 and that faces the bottom wall 110, to form a second extension portion 420 of the first protective layer 400. The first sealing member 300 is disposed between and is separately connected to the connection portion 213 of the display panel 210, the bottom wall 110 of the middle frame 100, and the second extension portion 420.

That is, the connection portion 213 of the display panel 210, the bottom wall 110 of the middle frame 100, and the second extension portion 420 are all fastened to the first sealing member 300, to form an integrated structure, thereby helping improve structural stability of the display module 200. Specifically, the first protective layer 400 may be an adhesive layer, and is prepared through an adhesive dispensing process.

In the embodiment shown in FIG. 4, the display module 200 further includes a second sheathing member 242. The second sheathing member 242 sheathes an outside of the circuit board 220 and an outside of the chip 230, and is located between both of the circuit board 220 and the chip 230 and the bottom wall 110 of the middle frame 100. One end that is of the second sheathing member 242 and that is close to the first side wall 121 is spaced from the second extension portion 420 of the first protective layer 400 to form a third gap c. A portion of the first sealing member 300 is disposed in the third gap c, so that the first sealing member 300 is separately connected to the second sheathing member 242, the connection portion 213 of the display panel 210, the bottom wall 110 of the middle frame 100, and the second extension portion 420.

The first sheathing member 241 sheathes the outside of the circuit board 220 and the outside of the chip 230 to protect the circuit board 220 and the chip 230, thereby reducing cases of damaging the circuit board 220 and the chip 230, and helping improve reliability of the display module 200. The second sheathing member 242, the connection portion 213 of the display panel 210, the bottom wall 110 of the middle frame 100, and the second extension portion 420 are all fastened to the first sealing member 300 to form an integrated structure, thereby helping improve structural stability of the display module 200. Specifically, the second sheathing member 242 may also be a TAPE (tape).

In the embodiment shown in FIG. 4, the first sealing member 300 includes a transition layer 310 and a first adhesive layer 320. The transition layer 310 of the first sealing member 300 is disposed in the third gap c. The first adhesive layer 320 is disposed between the transition layer 310 and the bottom wall 110 of the middle frame 100, and the transition layer 310 is fastened to the bottom wall 110 by using the first adhesive layer 320.

During preparation, the transition layer 310 may be first prepared in the third gap c to ensure that the transition layer 310 fully fills the third gap c to ensure connection reliability, and then the first adhesive layer 320 is prepared when the display module 200 and the middle frame 100 are assembled, to fasten the display module 200 to the middle frame 100.

In the embodiment shown in FIG. 4, a material of the transition layer 310 may be PET (polyethylene terephthalate), and the first adhesive layer 320 may be an adhesive.

PET has excellent physical and mechanical performance in a wide temperature range, can be used at a temperature up to 120°C, has excellent electrical insulation performance, and has good size stability. Therefore, PET is applicable to the display module 200. During preparation, PET may be prepared before the bent portion 211 is formed on the display panel 210 through bending, to implement a flat PET surface.

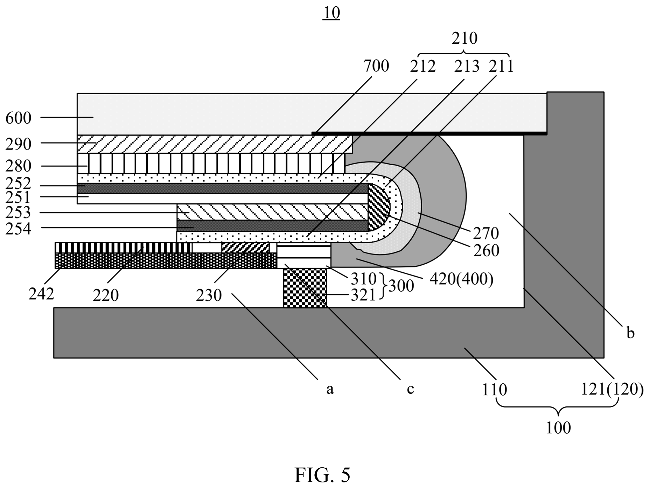

In another embodiment, as shown in FIG. 5, the first adhesive layer 320 may be a back adhesive 321. A difference between the embodiment shown in FIG. 5 and the embodiment shown in FIG. 4 lies in that the first adhesive layer 320 in the embodiment shown in FIG. 4 is the adhesive, but the first adhesive layer 320 in the embodiment shown in FIG. 5 is the back adhesive 321. The back adhesive 321 is more favorable to disassembly than the adhesive.

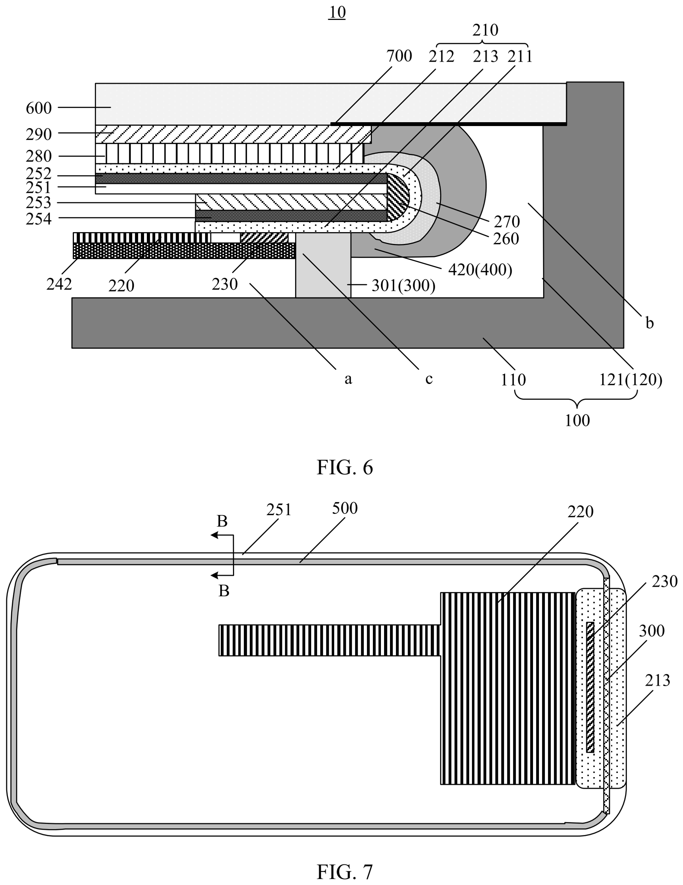

In another embodiment, as shown in FIG. 6, the first sealing member 300 may be a foam adhesive 301. A difference between the embodiment shown in FIG. 6 and the embodiment shown in FIG. 5 lies in that the first sealing member 300 in the embodiment shown in FIG. 6 is the foam adhesive 301, and does not include the transition layer 310.

Specifically, as shown in FIG. 6, the first sealing member 300 may be the foam adhesive 301. The foam adhesive 301 is disposed between and is separately connected to the connection portion 213 and the bottom wall 110 of the middle frame 100. One end that is of the foam adhesive 301 and that is far away from the bottom wall 110 of the middle frame 100 is located in the third gap c.

During preparation, a double-sided foam adhesive may be first coated in the third gap c. The display module 200 is directly adhered to the middle frame 100 by using the double-sided foam adhesive when being assembled with the middle frame 100, so that an operation is simple and costs are saved, thereby facilitating disassembly and reuse.

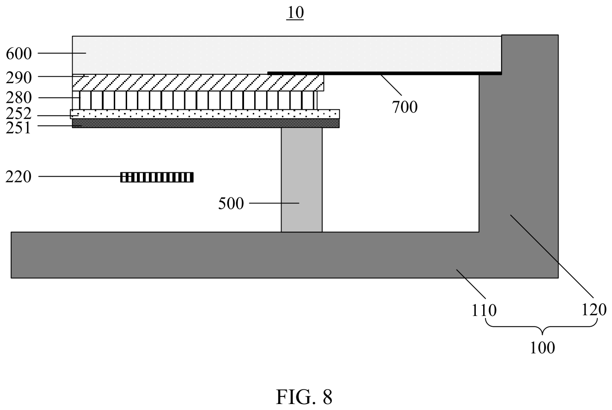

FIG. 7 is a diagram of a connection relationship of a heat dissipation layer 251, a connection portion 213, a circuit board 220, a chip 230, a first sealing member 300, and a second sealing member 500 according to an embodiment of this application. FIG. 8 is a sectional view of FIG. 7 in a direction B-B. As shown in FIG. 7, in some embodiments of this application, another position of the electronic device 10 further includes a second sealing member 500. The first sealing member 300 extends in an extension direction of the first side wall 121. Two ends of the first sealing member 300 are respectively connected to two ends of the second sealing member 500 to form a ring-shaped structure. An orthographic projection of the heat dissipation layer 251 on the display portion 212 covers orthographic projections of the circuit board 220, the chip 230, the first sealing member 300, and the second sealing member 500 on the display portion 212. The heat dissipation layer 251, the bottom wall 110 of the middle frame 100, the first protective layer 400, the first sealing member 300, and the second sealing member 500 jointly constitute a sealing space, and the circuit board 220 and the chip 230 are located in the sealing space. Specifically, as shown in FIG. 8, the second sealing member 500 is disposed between the heat dissipation layer 251 and the bottom wall 110 of the middle frame 100 along an edge of the heat dissipation layer 251, and is separately fixedly connected to the heat dissipation layer 251 and the bottom wall 110 of the middle frame 100. In this way, sealing of the circuit board 220 and the chip 230 is implemented, and intrusion of external water and oxygen is avoided, thereby helping prolong a service life of the electronic device 10. Specifically, the second sealing member 500 may be any type of adhesive or may be another material that can implement water and oxygen isolation, provided that a sealing function can be implemented. This is not limited in this application.

In the embodiment shown in FIG. 7 and FIG. 8, there is a region in which an orthographic projection of the connection portion 213 on the bottom wall 110 overlaps with an orthographic projection of the first sealing member 300 on the bottom wall 110. The orthographic projection of the first sealing member 300 on the bottom wall 110 extends beyond the orthographic projection of the connection portion 213 on the bottom wall 110 in an extension direction of the orthographic projection of the first sealing member 300 on the bottom wall 110. The orthographic projection of the first sealing member 300 on the bottom wall 110 falls within a range of the orthographic projection of the connection portion 213 on the bottom wall 110 in a direction perpendicular to the extension direction of the orthographic projection of the first sealing member 300 on the bottom wall 110.

In some other embodiments of this application, the orthographic projection of the connection portion 213 on the bottom wall 110 covers the orthographic projection of the first sealing member 300 on the bottom wall 110. The first sealing member 300 may be disposed in any range, provided that a sealing requirement can be met. This is not limited in this application.

It can be understood that the first sealing member 300 in the embodiment shown in FIG. 7 and FIG. 8 may be any one of the foregoing first sealing members 300 shown in FIG. 3 to FIG. 6.

It should be noted that in the examples and specification of this patent, relational terms such as first and second are only used to distinguish one entity or operation from another entity or operation, and do not necessarily require or imply that there is any such actual relationship or order between these entities or operations. In addition, the term "include", "comprise", or any other variant thereof is intended to cover non-exclusive inclusion, so that a process, method, article, or device that includes a series of elements includes not only those elements but also other elements that are not expressly listed, or includes elements inherent to such a process, method, article, or device. Without further limitation, the element defined by the sentence "including a" does not exclude that other identical elements also exist in the process, method, article, or device including the element.

Although this application has been illustrated or described with reference to some preferred embodiments of this application, a person of ordinary skill in the art should understand that various modifications may be made to forms and details without departing from the spirit and scope of this application.

## Claims

1. An electronic device, wherein the electronic device comprises a middle frame, a display module, and a first sealing member;
the middle frame comprises a bottom wall and a side wall, and the bottom wall and the side wall jointly constitute an accommodating space;
the display module is mounted in the accommodating space, and the display module is parallel to the bottom wall of the middle frame;
the display module comprises a display panel, a bent portion is formed at one end of the display panel, there is a first gap between one side that is of the display module and that comprises the bent portion and the bottom wall of the middle frame, there is a second gap between the side that is of the display module and that comprises the bent portion and a first side wall of the middle frame, and the first side wall is a side wall opposite to the bent portion;
the first sealing member is disposed at one end that is of the display module and that comprises the bent portion, and is located in the first gap; and
an orthographic projection of the first sealing member on the bottom wall of the middle frame is located in a range of an orthographic projection of the display module on the bottom wall of the middle frame, and the first sealing member is not in contact with the first side wall of the middle frame.

2. The electronic device according to claim 1, wherein
the display panel further comprises a display portion and a connection portion, the display portion is connected to the connection portion by using the bent portion, and the bent portion and the connection portion are formed by bending an extension region of the display portion toward a back side of the display portion, so that the connection portion is formed between the back side of the display portion and the bottom wall of the middle frame; and
the electronic device further comprises a first protective layer, and the first protective layer sheathes an outside of the bent portion, is located between the bent portion, the first side wall, and the bottom wall, and is not in contact with the first side wall and the bottom wall.

3. The electronic device according to claim 2, wherein
one end that is of the first protective layer and that is close to the bottom wall extends from the bent portion to the first gap in a direction away from the first side wall, to form a first extension portion of the first protective layer; and
the first sealing member is located between and is separately connected to the first extension portion and the bottom wall of the middle frame.

4. The electronic device according to claim 3, wherein the display module further comprises a circuit board, a chip, and a first sheathing member;
the circuit board and the chip are disposed on one side that is of the connection portion and that faces the bottom wall of the middle frame;
the first sheathing member sheathes an outside of the circuit board and an outside of the chip, and is located between both of the circuit board and the chip and the bottom wall of the middle frame, and the first gap is formed between the first sheathing member and the bottom wall; and
the first extension portion of the first protective layer covers a portion of one end that is of the first sheathing member and that is close to the first side wall.

5. The electronic device according to claim 3, wherein the first sealing member is an adhesive and is prepared on the bottom wall of the middle frame through an adhesive dispensing process.

6. The electronic device according to claim 2, wherein
one end that is of the first protective layer and that is close to the bottom wall extends, in a direction away from the first side wall, from the bent portion to one side that is of the connection portion and that faces the bottom wall, to form a second extension portion of the first protective layer; and
the first sealing member is disposed between and separately connected to the connection portion of the display panel, the bottom wall of the middle frame, and the second extension portion.

7. The electronic device according to claim 6, wherein the display module further comprises a circuit board, a chip, and a second sheathing member;
the circuit board and the chip are disposed on the side that is of the connection portion and that faces the bottom wall of the middle frame;
the second sheathing member sheathes an outside of the circuit board and an outside of the chip, and is located between both of the circuit board and the chip and the bottom wall of the middle frame; and
one end that is of the second sheathing member and that is close to the first side wall is spaced from the second extension portion of the first protective layer to form a third gap, and a portion of the first sealing member is disposed in the third gap, so that the first sealing member is separately connected to the second sheathing member, the connection portion of the display panel, the bottom wall of the middle frame, and the second extension portion.

8. The electronic device according to claim 7, wherein the first sealing member comprises a transition layer and a first adhesive layer;
the transition layer of the first sealing member is disposed in the third gap; and
the first adhesive layer is disposed between the transition layer and the bottom wall of the middle frame, and the transition layer is fastened to the bottom wall by using the first adhesive layer.

9. The electronic device according to claim 8, wherein a material of the transition layer is PET, and the first adhesive layer is a back adhesive or an adhesive.

10. The electronic device according to claim 7, wherein the first sealing member is a foam adhesive, and the foam adhesive is disposed between and separately connected to the connection portion and the bottom wall of the middle frame; and
one end that is of the foam adhesive and that is far away from the bottom wall of the middle frame is located in the third gap.

11. The electronic device according to claim 4 or 7 or 8 or 9 or 10, wherein the display module further comprises a heat dissipation layer, and the heat dissipation layer is located on one side that is of the display portion of the display panel and that faces the bottom wall of the middle frame;
the electronic device further comprises a second sealing member, and the second sealing member is disposed between the heat dissipation layer and the bottom wall of the middle frame along an edge of the heat dissipation layer, and is separately fixedly connected to the heat dissipation layer and the bottom wall of the middle frame;
the first sealing member extends in an extension direction of the first side wall, and two ends of the first sealing member are respectively connected to two ends of the second sealing member to form a ring-shaped structure;
an orthographic projection of the heat dissipation layer on the display portion covers orthographic projections of the circuit board, the chip, the first sealing member, and the second sealing member on the display portion; and
the heat dissipation layer, the bottom wall of the middle frame, the first protective layer, the first sealing member, and the second sealing member jointly constitute a sealing space, and the circuit board and the chip are located in the sealing space.

12. The electronic device according to claim 11, wherein the display module further comprises a first backplane, a second adhesive layer, and a second backplane;
the first backplane is located between the display portion of the display panel and the heat dissipation layer, the second backplane is located on one side that is of the connection portion of the display panel and that is far away from the bottom wall of the middle frame, and the second adhesive layer is located between the heat dissipation layer and the second backplane, and is configured to fasten the heat dissipation layer and the second backplane;
the bent portion of the display panel is in an arc shape, and protrudes toward the first side wall of the middle frame to form an accommodating cavity; and
a support member fully filling an entire space of the accommodating cavity is disposed in the accommodating cavity.

13. The electronic device according to claim 12, wherein the display module further comprises a second protective layer; and
the second protective layer is disposed between the first protective layer and the bent portion, the second protective layer sheathes the outside of the bent portion, and the first protective layer sheathes an outside of the second protective layer.

14. The electronic device according to claim 13, wherein the display module further comprises a polarizer and an optically clear adhesive layer, the polarizer is disposed on one side that is of the display portion and that is far away from the bottom wall, and the optically clear adhesive layer is disposed on one side that is of the polarizer and that is far away from the display portion;
the electronic device further comprises a cover glass and an ink layer;
a stepped structure is formed on the side wall of the middle frame, and the cover glass is fixedly connected to the side wall of the middle frame by using the stepped structure;
the display module is disposed between the middle frame and the cover glass, and the cover glass is fastened to the display module by using the optically clear adhesive layer; and
the ink layer is disposed between the cover glass and the side wall of the middle frame, is located between the optically clear adhesive layer and the cover glass, and covers the second gap.
